# EUROPÄISCHE PATENTANMELDUNG

(11) **EP 4 822 970 A1**
(43) Veröffentlichungstag der Anmeldung: **14.10.2026**
(21) Anmeldenummer: 26159173.9
(22) Anmeldetag: 17.02.2026
(51) Int. Cl.: H02M 1/32, G01R 31/26

(54) **VERFAHREN ZUR ERMITTLUNG EINES GESUNDHEITSZUSTANDS VON LEISTUNGSHALBLEITERSCHALTERN UND SCHALTUNGSANORDNUNG**

(30) Priorität: 07.03.2025 DE 102025108830
(71) Anmelder: Volkswagen Aktiengesellschaft, 38440 Wolfsburg (DE)
(72) Erfinder: Otto, Alexander, 38440 Wolfsburg (DE); Tashakor, Nima, 38440 Wolfsburg (DE)

(57) **Zusammenfassung**

Die Erfindung betrifft ein Verfahren zur Ermittlung eines Gesundheitszustandes von Leistungshalbleiterschalterschaltern (S1-S6) eines Wechselrichters (3), mittels mindestens eines Zwischenkreiskondensators (4), einer Spannungsmesseinrichtung (6) und mindestens eines Entladewiderstandes (8, 13), wobei der Zwischenkreiskondensator (4) über Schaltelemente (11) mit einer Hochvoltbatterie (2) verbunden ist, umfassend die folgenden Schritte:
a) Öffnen der Schaltelemente (11) zwischen Zwischenkreiskondensator (4) und Hochvoltbatterie (2),
b) Erfassen einer Ausgangsspannung (U₀) am Zwischenkreiskondensator (4) als Startwert,
c) Entladen des Zwischenkreiskondensators (4) über den mindestens einen Entladewiderstand (8, 13) bis zu mindestens einem Schwellwert, wobei während des Entladens alle Leistungshalbleiterschalterschalter (S1-S6) des Wechselrichters (3) oder einige Leistungshalbleiterschalterschalter (S1-S6) des Wechselrichters (3) gesperrt sind, sodass kein aktiver Kurzschluss einer Halbbrücke vorliegt,
d) Ermitteln einer Zeit und/oder einer Zeitkonstanten (τ₂) mit einer abgelegten Zeit und/oder Zeitkonstanten (τ₁), wobei anhand der Abweichung auf einen Gesundheitszustand der Leistungshalbleiterschalterschalter (S1-S6) geschlossen wird,
sowie eine Schaltungsanordnung.

## Beschreibung

Die Erfindung betrifft ein Verfahren zur Ermittlung eines Gesundheitszustands von Leistungshalbleiterschaltern eines Wechselrichters und eine Schaltungsanordnung.

Leistungshalbleiterschalter, welche das Herzstück eines Wechselrichters, insbesondere eines Pulswechselrichters, bilden, sind während des Betriebes u.a. hohen elektrischen sowie thermischen bzw. thermomechanischen Beanspruchungen ausgesetzt, welche zu Alterungserscheinungen und somit zu Zuverlässigkeits- und Lebensdauerproblemen führen können. Daher ist die Ermittlung eines Gesundheitszustandes von Leistungshalbleiterschaltern eines Wechselrichters von großer Bedeutung, um möglichst frühzeitig auf Probleme hinzuweisen, um entweder die Leistungshalbleiterschalter vor Ausfall auszutauschen oder die Betriebsstrategie anzupassen, um die Belastung zu reduzieren.

Aus der DE 10 2019 129 728 A1 ist ein Verfahren zum Überwachen zumindest eines Halbbrücken-Leistungsmoduls eines Umrichters bekannt, wobei das Halbbrücken-Leistungsmodul einen ersten Schalter und einen zweiten Schalter aufweist, mit den folgenden Schritten:
- Ausschalten der Schalter,
- Vorladen eines Zwischenkreiskondensators des Umrichters mit einer Zwischenkreisspannung,
- Einprägen eines Konstantstromes in einen Phasenanschluss des Halbbrücken-Leistungsmoduls,
- Auswerten einer sich über den Schaltern einstellenden Spannung und
- Ermitteln einer Degradation des Halbbrücken-Leistungsmoduls auf Basis der Auswertung der Spannung.

Dabei wird u.a. ausgenutzt, dass sich bei einer Degradation des Halbbrücken-Leistungsmoduls sich die Leckströme im ausgeschalteten Zustand erhöhen.

Der Erfindung liegt das technische Problem zugrunde, ein Verfahren zur Ermittlung eines Gesundheitszustandes von Leistungshalbleiterschaltern eines Wechselrichters zur Verfügung zu stellen, dass sich einfacher umsetzen lässt, sowie eine entsprechende Schaltungsanordnung zu schaffen.

Die Lösung des technischen Problems ergibt sich durch ein Verfahren mit den Merkmalen des Anspruchs 1 oder 7 sowie eine Schaltungsanordnung mit den Merkmalen des Anspruchs 6 oder 8. Weitere vorteilhafte Ausgestaltungen der Erfindung ergeben sich aus den Unteransprüchen.

Das Verfahren zur Ermittlung eines Gesundheitszustandes von Leistungshalbleiterschaltern eines Wechselrichters erfolgt mittels mindestens eines Zwischenkreiskondensators, einer Spannungsmesseinrichtung und mindestens eines Entladewiderstandes, wobei der Zwischenkreiskondensator über Schaltelemente mit einer Hochvoltbatterie verbunden ist. Dabei werden zunächst die Schaltelemente zwischen Zwischenkreiskondensator und Hochvoltbatterie geöffnet.

Die Ausgangsspannung am Zwischenkreiskondensator wird als Startwert von der Spannungsmesseinrichtung erfasst. Über den mindestens einen Entladewiderstand wird dann der Zwischenkreiskondensator bis zu mindesten seinem Schwellwert entladen. Dabei sind während des Entladens alle Leistungshalbleiterschalter gesperrt oder es sind zumindest einige Leistungshalbleiterschalter gesperrt, sodass kein aktiver Kurzschluss einer Halbbrücke vorliegt, was später noch näher erläutert wird. Es wird die Zeit ermittelt, die für die Entladung vom Startwert bis zum Schwellwert benötigt wurde. Alternativ oder ergänzend wird eine Zeitkonstante ermittelt. Diese ermittelte Zeit und/oder Zeitkonstante wird mit einer abgelegten Zeit und/oder Zeitkonstanten verglichen, wobei anhand der Abweichung auf einen Gesundheitszustand der Leistungshalbleiterschalter geschlossen wird. Die abgelegte Zeit bzw. Zeitkonstante sind dabei Referenzwerte bei gesunden Leistungshalbleiterschaltern. Der Vorteil des Verfahrens ist, dass nahezu alle benötigten Elemente bereits ohnehin vorhanden sind. Dabei wird Folgendes ausgenutzt. Im gesunden Zustand ist der Leckstrom der Leistungshalbleiterschalter im Bereich weniger µA. Im gesunden Zustand ist also die Zeitkonstante für die Entladung durch den Widerstandswert des Entladewiderstandes und die Kapazität des Zwischenkreiskondensators bestimmt. Bei steigender Degradation (Alterung) der Leistungshalbleiterschalter steigt der Leckstrom auf beispielsweise 10 - 100 µA, d.h. ein größerer Teil des Entladestromes fließt über die Leistungshalbleiterschalter. Der Entladevorgang wird also beschleunigt. Anschaulich sinkt die Zeitkonstante. Wird nun also eine kürzere Zeit bzw. eine kleinere Zeitkonstante ermittelt, so spricht dies für eine Degradation. Dabei kann ein Schwellwert für die Abweichung festgelegt werden, ab dem eine Warnmeldung erzeugt wird.

Insbesondere wenn der Wechselrichter ein Wechselrichter eines Traktionsantriebes eines Elektro- oder Hybridfahrzeugs ist, lässt sich das Verfahren besonders einfach implementieren.

Bei Elektro- oder Hybridfahrzeugen wird häufig in bestimmten Situationen der Zwischenkreiskondensator gezielt entladen, beispielsweise wenn das Fahrzeug abgestellt wird.

Dieses ohnehin durchgeführte Entladen kann nun einfach zur Ermittlung des Gesundheitszustandes erweitert werden. Zum Entladen eines Zwischenkreiskondensators sind verschiedene Verfahren bekannt. Bei einem passiven Entladen wird ein großer Widerstand zwischen HV+ und HV- genutzt. Des Weiteren sind auch aktive Entladeschaltungen bekannt, die aus einer Reihenschaltung von einem Halbleiterschalter und einem Widerstand bestehen. Dabei ist typischerweise der Widerstand einer aktiven Entladeschaltung kleiner als der einer passiven Entladeschaltung. Beispielsweise dauert eine passive Entladung ca. 2 Minuten, wohingegen eine aktive Entladung in wenigen Sekunden (z.B. 10 Sekunden) erfolgt. Der Einfluss der Leckströme ist dabei umso größer, je länger die Entladung dauert.

Ist also eine passive Entladeschaltung bzw. ein passiver Entladewiderstand vorhanden, so wird vorzugsweise die Entladung für das Verfahren mittels des passiven Entladewiderstandes durchgeführt, wobei eine gegebenenfalls auch vorhandene aktive Entladeschaltung deaktiviert bleibt.

Ist hingegen kein passiver Entladewiderstand vorhanden, so kann auch die Entladung über die aktive Entladeschaltung durchgeführt werden, wobei dann vorzugsweise das Schaltelement während des Entladens zeitweise gesperrt wird (z.B. im Pulsbetrieb angesteuert wird) oder im Linearbetrieb angesteuert, um so den Entladevorgang zu verzögern, sodass die Entladezeit entsprechend lang ist.

In einer weiteren Ausführungsform erfolgt der Vergleich der ermittelten Zeit und/oder Zeitkonstanten mit der abgelegten Zeit und/oder Zeitkonstanten in einer Vergleichseinheit, wobei in der Vergleichseinheit Alterungsmodelle für die Kapazität des Zwischenkreiskondensators und/oder den Widerstandswert des Entladewiderstandes abgelegt sind, die zur Nachführung der abgelegten Zeit und/oder Zeitkonstanten verwendet werden. Hierdurch ist der Vergleich aussagekräftiger und genauer.

In einer weiteren Ausführungsform wird das Verfahren mehrmals wiederholt, wobei jeweils andere Leistungshalbleiterschalter gesperrt sind. Hierdurch lässt sich der Gesundheitszustand genauer den einzelnen Leistungshalbleiterschaltern bzw. Gruppen von Leistungshalbleiterschaltern zuordnen. So kann beispielsweise das Verfahren einmal durchgeführt werden, wenn alle High-Side-Schalter durchgeschaltet sind und alle Low-Side-Schalter sperren und das andere Mal alle High-Side-Schalter gesperrt sind und alle Low-Side-Schalter durchgeschaltet sind. Durch den Vergleich der Zeit und/oder Zeitkonstanten kann so ermittelt werden, ob die oder einer der High-Side-Schalter stärker gealtert ist oder die oder einer der Low-Side-Schalter stärker gealtert ist. Dabei kann auch vorgesehen sein, dass das Verfahren wiederholt durchgeführt wird, wobei jeweils nur ein Leistungshalbleiterschalter durchgeschaltet ist. Der durchgeschaltete Leistungshalbleiterschalter hat keinen Leckstrom. Wenn also die ermittelte Zeitkonstante immer kleiner ist, wenn ein spezieller Leistungshalbleiterschalter gesperrt ist (im Vergleich wenn dieser durchgeschaltet ist), so spricht dies für einen schlechten Gesundheitszustand dieses einen Leistungshalbleiterschalters.

Die Schaltungsanordnung umfasst eine Hochvoltbatterie, mindestens einen Zwischenkreiskondensator, einen Wechselrichter mit Leistungshalbleiterschalter, Schaltelemente, die zwischen der Hochvoltbatterie und dem Zwischenkreiskondensator angeordnet sind, eine Spannungsmesseinrichtung zur Erfassung der Spannung am Zwischenkreiskondensator, eine Vergleichseinheit und mindestens einen Entladewiderstand, wobei die Schaltungsanordnung derart ausgebildet ist, in definierten Situationen die Schaltelemente zu öffnen und eine Ausgangsspannung am Zwischenkreiskondensator zu erfassen, wobei die Schaltungsanordnung weiter derart ausgebildet ist, eine Zeit bis zum Erreichen eines Schwellwertes der Spannung am Zwischenkreiskondensator zu erfassen, wobei die Vergleichseinheit derart ausgebildet ist, die erfasste Zeit und/oder eine ermittelte Zeitkonstante mit einer abgelegten Zeit und/oder einer Zeitkonstanten zu vergleichen und anhand einer Abweichung auf einen Gesundheitszustand der Leistungshalbleiterschalter zu schließen. Hinsichtlich der weiteren Ausgestaltungen wird auf die vorangegangenen Ausführungen Bezug genommen.

Der Schwellwert kann eine feste Spannungsgrenze sein (z.B. 30 V) oder aber ein prozentualer Wert vom Startwert sein (z.B. 10 %). Ist also beispielsweise der Startwert 580 V, so kann der Schwellwert beispielsweise 58 V sein. Dabei sei angemerkt, dass der Entladevorgang auch nach Erreichen des Schwellwertes fortgesetzt werden kann, um den Kondensator vollständig zu entladen.

Die Leistungshalbleiterschalter können dabei MOSFETs (Si oder SiC), IGBTs oder GaN HEMTs sein.

In einer alternativen oder ergänzenden Ausführungsform erfolgt eine Ermittlung des Gesundheitszustandes von Leistungshalbleiterschaltern eines Wechselrichters mittels Erfassung einer Überspannungsamplitude.

Hierzu ist den Leistungshalbleiterschaltern eine Spannungsmesseinrichtung zugeordnet, die die Spannung über Drain und Source bzw. Kollektor und Emitter erfasst, wobei die Überspannungsamplitude mindestens beim Einschalten der Leistungshalbleiterschalter erfasst wird, wobei durch Vergleich der erfassten Überspannungsamplitude mit einer abgelegten Überspannungsamplitude auf den Gesundheitszustand der einzelnen Leistungshalbleiterschalter geschlossen wird. Die Spannungsmesseinrichtungen sind dabei typischerweise in den vorhandenen Überspannungsschutzschaltungen (Desaturierungserkennung) bereits vorhanden. Dem liegt folgende Erkenntnis zugrunde. Die Überspannungsamplitude resultiert durch eine parasitäre Induktivität und ist proportional zur parasitären Induktivität und der Stromsteilheit di/dt. Vergrößert sich also der Einschaltwiderstand des Leistungshalbleiterschalters (z.B. durch eine Degradation in der Aufbau- und Verbindungstechnik oder aufgrund einer driftenden Schwellspannung, so führt dies zu einer Reduzierung der Steilheit di/dt und damit der Überspannungsamplitude, sodass eine abnehmende Überspannungsamplitude einen sich verschlechternden Gesundheitszustand ausdrückt. Die driftende Schwellspannung kann beispielsweise aufgrund einer Degradation des Gate-Oxids oder aufgrund des Degradationsphänomens "Bias Temperature Instability BTI" erfolgen, wobei die Schwellspannung steigt. Wird während des Betriebes die Gate-Spannung nicht nachgeführt, so führt die erhöhte Schwellspannung zu einem erhöhten Einschaltwiderstand. Ein weiterer Degradationseffekt ist eine sich ändernde Gate-Source-Kapazität, die wie ein parasitärer RC-Filter wirkt, welcher die maximale transiente Überspannung über der Gate-Ladung des Schalters sowie die Sättigungsspannung beeinflusst (typischerweise erhöht). Auch dies führt zu einer Verringerung der Überspannungsamplitude. Durch Vergleich der Überspannungsamplitude kann so eine Degradation des Leistungshalbleiterschalters detektiert werden, jedoch keine Aussage über die Ursache, was also bezüglich einer Warnung hinsichtlich eines Ausfalls des Leistungshalbleiterschalters aber nicht weiter beachtlich ist, da es für die Warnung keine Rolle spielt, warum der Leistungshalbleiterschalter droht auszufallen. Die Schaltzeiten sind darüber hinaus auch von der Stromamplitude (höherer Strom führt zu verlängerten Schaltzeiten), Spannungsamplitude (höhere Spannung führt zu verlängerten Schaltzeiten) sowie Temperatur (höhere Temperatur führt zu verkürzten Schaltzeiten) abhängig, sodass diese vorzugsweise beim Vergleich berücksichtigt werden. Hierzu sind beispielsweise Kennfelder für die Überspannungsamplitude in Abhängigkeit der Parameter abgelegt, wobei Kennfelder auch als Lookup-Tabelle ausgebildet sein können.

Die Erfindung wird nachfolgend anhand bevorzugter Ausführungsbeispiele näher erläutert. Die Figuren zeigen:
- Fig. 1: eine schematische Schaltungsanordnung eines Traktionsnetzes eines Elektro- oder Hybridfahrzeuges und
- Fig. 2: eine schematische Darstellung eines Spannungsverlaufs über einen Zwischenkreiskondensator bei einer Entladung.

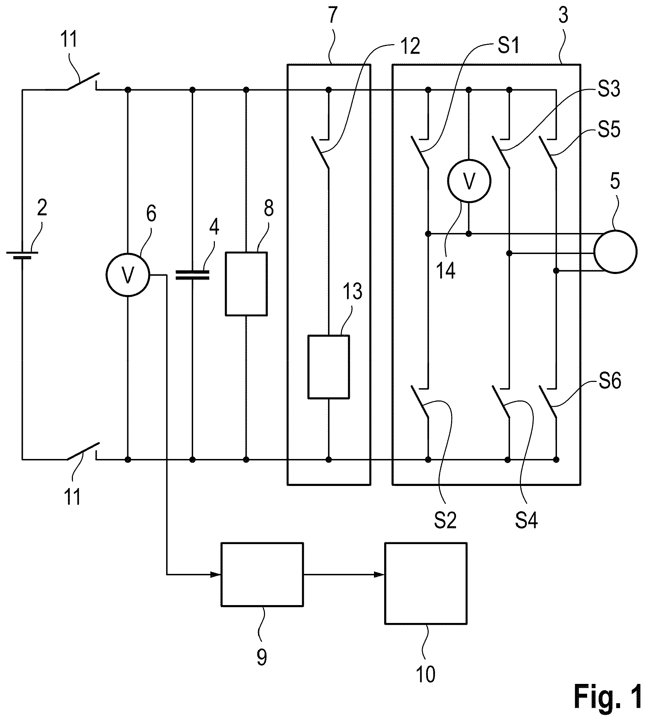

In der Fig. 1 ist schematisch ein Traktionsnetz 1 eines Elektro- oder Hybridfahrzeuges dargestellt, umfassend eine Hochvoltbatterie 2, einen Wechselrichter 3, mindestens einen Zwischenkreiskondensator 4, eine Elektromaschine 5, eine Spannungsmesseinrichtung 6, eine aktive Entladeschaltung 7, einen passiven Entladewiderstand 8, eine Vergleichseinheit 9 und eine Anzeigeeinheit 10. Zwischen der Hochvoltbatterie 2 und dem Zwischenkreiskondensator 4 sind Schaltelemente 11 angeordnet, um die Hochvoltbatterie 2 vom Zwischenkreiskondensator 4 abtrennen zu können, wobei die Schaltelemente 11 vorzugsweise als Hochvolt-Schütze ausgebildet sind. Die aktive Entladeschaltung 7 weist ein Schaltelement 12 und einen Widerstand 13 auf, wobei das Schaltelement 12 beispielsweise als MOSFET ausgebildet ist. Dabei ist der Widerstandswert vom Widerstand 13 erheblich kleiner als der Widerstandswert des passiven Entladewiderstandes 8 (vorzugsweise mindestens eine Größenordnung). Der Wechselrichter 3 weist mindestens sechs Leistungshalbleiterschalterschalter S1-S6 auf, die hier als B6-Brücke dargestellt sind. Grundsätzlich kann der Wechselrichter 3 aber auch ein 3-Level-Wechselrichter sein. Die Leistungshalbleiterschalterschalter S1-S6 sind beispielsweise IGBTs mit Freilaufdioden, MOSFETs oder GaN HEMTs. Dabei bilden die Leistungshalbleiterschalterschalter S1, S3, S5 die High-Side-Schalter und die Leistungshalbleiterschalterschalter S2, S4, S6 die Low-Side-Schalter. In bestimmten Situationen muss der Zwischenkreiskondensator 4 entladen werden. Eine solche Situation ist beispielsweise ein Crash oder wenn das Fahrzeug abgestellt wird. Im Crashfall muss die Entladung schnell erfolgen, wobei dies dann über die aktive Entladeschaltung 7 erfolgt. Beim Abstellen ist dies nicht zwingend, aber es kann auch über die aktive Entladeschaltung 7 entladen werden. Der passive Entladewiderstand 8 stellt dann sicher, dass auch bei einer defekten aktiven Entladeschaltung 7 auf jeden Fall der Zwischenkreiskondensator 4 entladen wird.

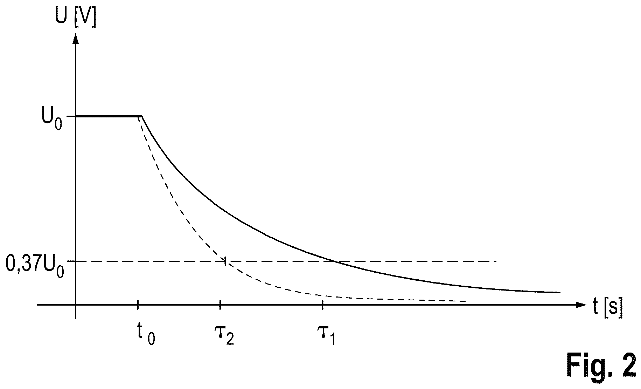

Dieser passive Entladewiderstand 8 wird nun erfindungsgemäß ausgenutzt, um den Gesundheitszustand der Leistungshalbleiterschalterschalter S1-S6 zu ermitteln. Hierzu wird beispielsweise das Verfahren nach dem Abstellen des Fahrzeugs durchgeführt. Dabei werden zunächst die Schaltelemente 11 geöffnet und mittels der Spannungsmesseinrichtung 6 die Ausgangsspannung am Zwischenkreiskondensator 4 erfasst und als Startwert in der Vergleichseinheit 9 abgespeichert. Die aktive Entladeschaltung 7 ist deaktiviert, also das Schaltelement 12 geöffnet. Ebenso sind die Leistungshalbleiterschalterschalter S1-S6 offen bzw. gesperrt. Im gesunden Zustand ist der Leckstrom durch die Halbleiterschalter S1-S6 sehr gering und beispielsweise im einstelligen µA-Bereich. Unter Vernachlässigung der Leckströme ist die Zeitkonstante τ₁= R · C, wobei R der Widerstandswert des Entladewiderstandes 12 ist und C die Kapazität des Zwischenkreiskondensators 4. Anschaulich ist die Zeitkonstante τ₁ die Zeit, bis sich der Zwischenkreiskondensator von einer Ausgangsspannung U₀ auf 0,37 U₀ (entspricht 1/e) entladen hat, was schematisch in Fig. 2 dargestellt ist. Dabei kann τ₁ zu Beginn der Lebenszeit messtechnisch bestimmt werden, sodass auch die niedrigen Leckströme berücksichtigt werden. Altern nun die Leistungshalbleiterschalterschalter S1-S6, so nimmt deren Leckstrom zu (z.B. auf 10-100 µA). Diese Zunahme des Leckstroms ist gleichwirkend, als ob der Widerstandswert R kleiner geworden wäre, sodass sich mit der Alterung eine neue Zeitkonstante τ₂ einstellt, die kleiner als die ursprüngliche Zeitkonstante τ₁ ist. Durch Messung der Spannung kann diese Zeitkonstante τ₂ gemessen bzw. ermittelt werden und in der Vergleichseinheit 9 mit der abgelegten ursprünglichen Zeitkonstante τ₁ verglichen werden, wobei bei einer Abweichung (absolut oder prozentual) größer einem Schwellwert eine Warnmeldung für die Anzeigeeinheit 10 erzeugt wird. Die Warnungen können dabei gestuft erfolgen.

Durch Variation, welche der Leistungshalbleiterschalter gesperrt sind, wobei mindestens ein Leistungshalbleiterschalter durchgeschaltet wird, lässt sich darüber hinaus eingrenzen, welcher der Leistungshalbleiterschalter S1-S6 den größten Leckstrom aufweist. Da nicht nur die Leistungshalbleiterschalterschalter S1-S6 der Alterung unterliegen, sondern auch der Entladewiderstand 8 sowie der Zwischenkreiskondensator 4, können Alterungsmodelle für diese in der Vergleichseinheit 9 hinterlegt sein, um τ₁ über die Lebensdauer nachzuführen.

Alternativ oder ergänzend kann der Alterungszustand bzw. Gesundheitszustand der Leistungshalbleiterschalterschalter S1-S6 durch Auswerten einer Überspannungsamplitude mindestens beim Einschalten des Leistungshalbleiterschalterschalters S1-S6 ermittelt werden. Diese Überspannungsamplitude resultiert durch parasitäre Induktivitäten. Durch verschiedene Effekte nimmt mit zunehmender Alterung die Stromsteilheit di/dt ab (z.B. Drift der Schwellspannung, Degradation des Oxids etc.), was zu einer verringerten Überspannungsamplitude führt. Durch eine Spannungsmesseinrichtung 14 über den Leistungshalbleiterschalterschaltern S1-S6 kann die Überspannungsamplitude erfasst werden und mit einer abgelegten Überspannungsamplitude zu Beginn der Lebenszeit verglichen werden. Derartige Spannungsmesseinrichtungen 14 (nur dargestellt für den Leistungshalbleiterschalterschalter S1) sind typischerweise ohnehin verbaut und Bestandteil einer Überspannungsschutzeinrichtung, sodass kein zusätzlicher Hardware-Aufwand existiert.

### Bezugszeichenliste

- 1: Traktionsnetz
- 2: Hochvoltbatterie
- 3: Wechselrichter
- 4: Zwischenkreiskondensator
- 5: Elektromaschine
- 6: Spannungsmesseinrichtung
- 7: Entladeschaltung
- 8: Entladewiderstand
- 9: Vergleichseinheit
- 10: Anzeigeeinheit
- 11: Schaltelement
- 12: Schaltelement
- 13: Entladewiderstand
- 14: Spannungsmesseinrichtung
- C: Kapazität
- R: Widerstandswert
- S1-S6: Leistungshalbleiterschalterschalter
- U₀: Ausgangsspannung
- τ₁: Zeitkonstante
- τ₂: Zeitkonstante

## Patentansprüche

1. Verfahren zur Ermittlung eines Gesundheitszustandes von Leistungshalbleiterschalterschaltern (S1-S6) eines Wechselrichters (3), mittels mindestens eines Zwischenkreiskondensators (4), einer Spannungsmesseinrichtung (6) und mindestens eines Entladewiderstandes (8, 13), wobei der Zwischenkreiskondensator (4) über Schaltelemente (11) mit einer Hochvoltbatterie (2) verbunden ist, umfassend die folgenden Schritte:
a) Öffnen der Schaltelemente (11) zwischen Zwischenkreiskondensator (4) und Hochvoltbatterie (2),
b) Erfassen einer Ausgangsspannung (U₀) am Zwischenkreiskondensator (4) als Startwert,
c) Entladen des Zwischenkreiskondensators (4) über den mindestens einen Entladewiderstand (8, 13) bis zu mindestens einem Schwellwert, wobei während des Entladens alle Leistungshalbleiterschalterschalter (S1-S6) des Wechselrichters (3) oder einige Leistungshalbleiterschalterschalter (S1-S6) des Wechselrichters (3) gesperrt sind, sodass kein aktiver Kurzschluss einer Halbbrücke vorliegt,
d) Ermitteln einer Zeit und/oder einer Zeitkonstanten (τ₂) mit einer abgelegten Zeit und/oder Zeitkonstanten (τ₁), wobei anhand der Abweichung auf einen Gesundheitszustand der Leistungshalbleiterschalterschalter (S1-S6) geschlossen wird.

2. Verfahren nach Anspruch 1, **dadurch gekennzeichnet, dass** der Entladewiderstand (8) als passiver Entladewiderstand ausgebildet ist.

3. Verfahren nach Anspruch 1, **dadurch gekennzeichnet, dass** in Reihe zu dem Entladewiderstand (13) ein Schaltelement (12) angeordnet ist, wobei das Schaltelement (12) während des Entladens zeitweise gesperrt wird oder im Linearbetrieb angesteuert wird.

4. Verfahren nach einem der vorangegangenen Ansprüche, **dadurch gekennzeichnet, dass** der Vergleich der ermittelten Zeit und/oder Zeitkonstanten (τ₂) mit der abgelegten Zeit und/oder Zeitkonstanten (τ₁) in einer Vergleichseinheit (9) erfolgt, wobei in der Vergleichseinheit (9) Alterungsmodelle für die Kapazität (C) des Zwischenkreiskondensators (4) und/oder den Widerstandswert (R) des Entladewiderstandes (8, 13) abgelegt sind, die zur Nachführung der abgelegten Zeit und/oder Zeitkonstanten (τ₁) verwendet werden.

5. Verfahren nach einem der vorangegangenen Ansprüche, **dadurch gekennzeichnet, dass** das Verfahren mehrmals wiederholt wird, wobei jeweils andere Leistungshalbleiterschalterschalter (S1-S6) gesperrt sind.

6. Schaltungsanordnung, umfassend eine Hochvoltbatterie (2), mindestens einen Zwischenkreiskondensator (4), einen Wechselrichter (3) mit Leistungshalbleiterschalterschaltern (S1-S6), Schaltelemente (11), die zwischen der Hochvoltbatterie (2) und dem Zwischenkreiskondensator (4) angeordnet sind, eine Spannungsmesseinrichtung (6) zur Erfassung der Spannung am Zwischenkreiskondensator (4), eine Vergleichseinheit (9) und mindestens einen Entladewiderstand (8, 13), wobei die Schaltungsanordnung derart ausgebildet ist, in definierten Situationen die Schaltelemente (11) zu öffnen und eine Ausgangsspannung (Uₒ) am Zwischenkreiskondensator (4) zu erfassen, wobei die Schaltungsanordnung weiter derart ausgebildet ist, eine Zeit bis zum Erreichen eines Schwellwertes der Spannung am Zwischenkreiskondensator (4) zu erfassen, wobei die Vergleichseinheit (9) derart ausgebildet ist, die erfasste Zeit und/oder eine ermittelte Zeitkonstante (τ₂) mit einer abgelegten Zeit und/oder Zeitkonstanten (τ₁) zu vergleichen und anhand der Abweichung auf einen Gesundheitszustand der Leistungshalbleiterschalterschalter (S1-S6) zu schließen.

7. Verfahren zur Ermittlung eines Gesundheitszustandes von Leistungshalbleiterschalterschaltern (S1-S6) eines Wechselrichters (3), wobei den Leistungshalbleiterschalterschaltern (S1-S6) eine Spannungsmesseinrichtung (14) zugeordnet ist, wobei eine Überspannungsamplitude mindestens beim Einschalten der Leistungshalbleiterschalterschalter (S1-S6) erfasst wird, wobei durch Vergleich der erfassten Überspannungsamplitude mit einer abgelegten Überspannungsamplitude auf den Gesundheitszustand des einzelnen Leistungshalbleiterschalterschalters (S1-S6) geschlossen wird.

8. Schaltungsanordnung, umfassend einen Wechselrichter (3) mit Leistungshalbleiterschalterschalter (S1-S6), Spannungsmesseinrichtungen (6, 14), die die Spannung über den Leistungshalbleiterschalterschalter (S1-S6) erfassen, und eine Vergleichseinheit (9), wobei die Schaltungsanordnung derart ausgebildet ist, eine Überspannungsamplitude beim Einschalten der Leistungshalbleiterschalterschalter (S1-S6) zu erfassen, wobei die Vergleichseinheit (9) derart ausgebildet ist, anhand eines Vergleichs der erfassten Überspannungsamplitude mit einer abgelegten Überspannungsamplitude auf den Gesundheitszustand der Leistungshalbleiterschalterschalter (S1-S6) zu schließen.

9. Schaltungsanordnung nach Anspruch 8, **dadurch gekennzeichnet, dass** die Vergleichseinheit (9) derart ausgebildet ist, eine Spannungsamplitude und/oder eine Stromamplitude und/oder eine Temperatur des Leistungshalbleiterschalterschalters (S1-S6) beim Vergleich zu berücksichtigen.
